# FASCICULE DE BREVET EUROPEEN

(11) **EP 4 047 492 B1**
(45) Date de publication et mention de la délivrance du brevet: **18.11.2026**
(21) Numéro de dépôt: 22167109.2
(22) Date de dépôt: 25.06.2015
(51) Int. Cl.: G06F 17/17, G10L 19/04, G10L 21/00, H03H 17/02

(54) **RÉ-ÉCHANTILLONNAGE PAR INTERPOLATION D'UN SIGNAL AUDIO POUR UN CODAGE /DÉCODAGE À BAS RETARD**
NEUABTASTUNG DURCH INTERPOLATION EINES AUDIOSIGNALS FÜR EINE KODIERUNG/DEKODIERUNG MIT GERINGER VERZÖGERUNG
RESAMPLING BY INTERPOLATION OF AN AUDIO SIGNAL FOR ENCODING/DECODING WITH LOW DELAY

(30) Priorité: 27.06.2014 FR 1456077
(43) Date de publication de la demande: 24.08.2022
(62) Numéro(s) de document de la (des) demande(s) initiale(s) en application de l'article 76 CBE: 15745525.4 / 3 161 659
(73) Titulaire: Orange, 92130 Issy-les-Moulineaux (FR)
(72) Inventeur: KOVESI, Balazs, 92326 Châtillon Cedex (FR); RAGOT, Stéphane, 92326 Châtillon Cedex (FR)

(56) Documents cités:
- WO-A1-2012/085451
- SUNDER RAM KRISHNAN ET AL: "A Savitzky-Golay Filtering Perspective of Dynamic Feature Computation", IEEE SIGNAL PROCESSING LETTERS, IEEE, USA, vol. 20, no. 3, 1 March 2013 (2013-03-01), pages 281 - 284, XP011493614, ISSN: 1070-9908, DOI: 10.1109/LSP.2013.2244593
- ZÖLZER U ET AL: "INTERPOLATION ALGORITHMS: THEORY AND APPLICATION", 97TH AUDIO ENGINEERING SOCIETY CONVENTION PREPRINT, November 1994 (1994-11-01), XP008077712
- WISE D K ET AL: "Performance of low-order polynomial interpolators in the presence of oversampled input", September 1999 (1999-09-01), XP055192379, Retrieved from the Internet <URL:http://www.researchgate.net/profile/Robert_Bristow-Johnson/publication/266675823_Performance_of_Low-Order_Polynomial_Interpolators_in_the_Presence_of_Oversampled_Input/links/544811c30cf22b3c14e307b9.pdf> [retrieved on 20150529]
- FRANCK A: "Performance Evaluation of Algorithms for Arbitrary Sample Rate Conversion", 131ST AUDIO ENGINEERING SOCIETY CONVENTION, October 2011 (2011-10-01), XP040567626
- ABRAHAM SAVITZKY ET AL: "Smoothing and Differentiation of Data by Simplified Least Squares Procedures", ANALYTICAL CHEMISTRY, vol. 36, no. 8, 1 July 1964 (1964-07-01), pages 1627 - 1639, XP055340313, DOI: 10.1021/ac60214a047

## Description

La présente invention se rapporte au traitement d'un signal audiofréquence pour sa transmission ou son stockage. Plus particulièrement, l'invention se rapporte à un changement de fréquence d'échantillonnage lors d'un codage ou d'un décodage du signal audiofréquence.

De nombreuses techniques existent pour compresser (avec perte) un signal audiofréquence comme la parole ou la musique. Le codage peut s'effectuer directement à la fréquence d'échantillonnage du signal d'entrée, comme par exemple dans les recommandations IUT-T G.711 ou G.729 où le signal d'entrée est échantillonné à 8 kHz et le codeur et décodeur fonctionnent à cette même fréquence.

Cependant, certaines méthodes de codage utilisent un changement de fréquence d'échantillonnage, par exemple pour réduire la complexité du codage, adapter le codage en fonction des différentes sous-bandes fréquentielles à coder, ou convertir le signal d'entrée pour qu'il corresponde à une fréquence d'échantillonnage interne prédéfinie du codeur.

Dans le codage en sous-bandes défini dans la recommandation UIT-T G.722, le signal d'entrée à 16 kHz est divisé en 2 sous-bandes (échantillonnées à 8 kHz) qui sont codées séparément par un codeur de type MICDA (pour "Modulation par Impulsion et Codage Différentiel adaptatif", ADPCM en anglais). Cette division en 2 sous-bandes est effectuée par un banc de filtres miroirs en quadratique à réponse impulsionnelle finie (FIR en anglais pour "Finite Impulse Response"), d'ordre 23 qui occasionne en théorie un retard d'analyse-synthèse (codeur+décodeur) de 23 échantillons à 16 ms ; ce banc de filtre est mis en œuvre avec une réalisation en polyphase. La division en deux sous-bandes dans G.722 permet d'allouer de façon prédéterminée des débits différents aux deux sous-bandes en fonction de leur importance perceptuelle a priori et aussi de réduire la complexité totale de codage en exécutant deux codeurs de type MICDA à une fréquence plus faible. Par contre, elle induit un retard algorithmique par rapport à un codage MICDA direct.

Différentes méthodes de changement de fréquence d'échantillonnage, encore appelé ré-échantillonnage, d'un signal numérique sont connues, en utilisant par exemple et de façon non exhaustive, un filtre FIR (pour "Finite Impulse Response" en anglais, ou Réponse Impulsionnelle finie en français), un filtre IIR (pour "Infinite Impulse response" en anglais, ou Réponse Impulsionnelle infinie en français) ou une interpolation polynômiale (dont les splines). Une revue des méthodes classiques de ré-échantillonnage se trouve par exemple dans l'article R.W. Schafer, L.R. Rabiner, A Digital Signal Processing Approach to Interpolation, Proceedings of the IEEE, vol. 61, no. 6, June 1973, pp. 692 - 702

L'avantage du filtre FIR (symétrique) tient à sa mise en œuvre simplifiée et - sous certaines conditions - à la possibilité d'assurer une phase linéaire. Un filtrage à phase linéaire permet de préserver la forme d'onde du signal d'entrée, mais il peut aussi s'accompagner d'un étalement temporel (« ringing ») pouvant créer des artéfacts de type pré-échos sur des transitoires. Cette méthode occasionne un retard (qui est fonction de la longueur de la réponse impulsionnelle), en général de l'ordre de 1 à quelques ms pour assurer des caractéristiques de filtrage adéquates (ondulation dans la bande passante, niveau de réjection suffisant pour supprimer le repliement ou les images spectrales...).

Une autre alternative pour le ré-échantillonnage est l'utilisation d'une technique d'interpolation polynomiale. L'interpolation polynomiale est surtout efficace pour le sur-échantillonnage ou pour le sous-échantillonnage avec des fréquences proches (par exemple de 16 kHz à 12.8 kHz).

Pour les cas de sous-échantillonnage à fort rapport (par exemple de 32 kHz à 12.8 kHz), l'interpolation polynomiale n'est pas la méthode la plus adaptée car elle n'élimine pas les repliements dus aux hautes fréquences (dans l'exemple de sous-échantillonnage de 32 kHz à 12.8 kHz il s'agit des fréquences de 6.4 kHz à 16 kHz). L'avantage de l'interpolation polynomiale par rapport aux techniques avec filtrage est le faible retard voire un retard nul et aussi la complexité généralement moins élevée. L'utilisation d'interpolation est surtout avantageuse pour le ré-échantillonnage de vecteurs de faible longueur (de l'ordre de la dizaine d'échantillons) comme par exemple une mémoire de filtre, comme décrit ultérieurement dans un mode de réalisation de l'invention.

Les techniques d'interpolation polynomiale les plus connues et les plus utilisées sont l'interpolation linéaire, l'interpolation parabolique, l'interpolation cubique sous diverses variantes, selon le caractère local ou non de l'interpolation et selon les contraintes possibles de continuité des k-ième dérivées.

On considère ici plus en détail le cas simple de l'interpolation dite de Lagrange où l'on identifie les paramètres d'une courbe polynomiale à partir de points prédéfinis. On suppose que cette interpolation est répétée de façon locale si le nombre de points à interpoler est supérieur au nombre de points prédéfinis strictement nécessaires à l'interpolation. Dans l'état de l'art des techniques plus avancées telles que les "splines" d'interpolation ou les B-splines correspondant à des polynômes par morceaux avec contraintes de continuité des k-ième dérivées successives sont bien connues ; elles ne sont pas revues ici car l'invention s'en différencie.

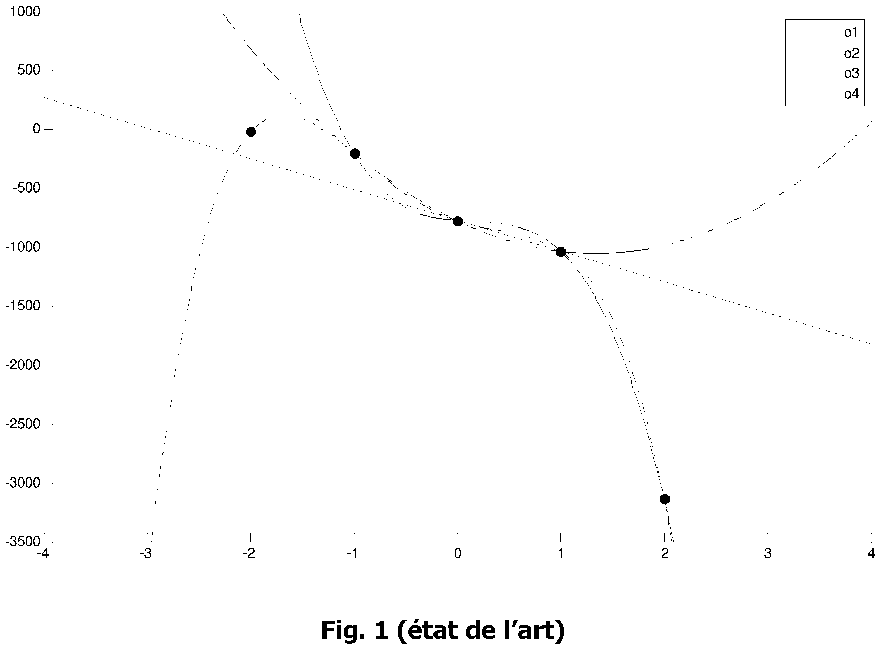

La **figure 1** montre une comparaison entre l'interpolation linéaire (o1, ligne en pointillé) d'ordre 1, l'interpolation parabolique (02, ligne discontinue) d'ordre 2, l'interpolation cubique (03, ligne pleine) d'ordre 3 et l'interpolation d'ordre 4 (o4, ligne mixte).

Pour l'interpolation linéaire, deux points déterminent une droite dont l'équation est vl(x)=a1*x+b1. Sur la figure 1 on a utilisé les points aux instants x=0 et x=1 qui délimitent l'intervalle [0, 1]. Si la valeur de ces points est v(0) et v(1) respectivement, on obtient les coefficients a1 et b1 comme suit : $a 1 = v \left(1\right) - v \left(0\right)$ $b 1 = v \left(0\right)$ L'obtention des coefficients a1 et b1 d'une droite s'effectue à l'aide d'une seule opération d'addition et le calcul d'un échantillon interpolé vl(x) coûte une opération addition et une opération multiplication ou une opération multiplication-addition (MAC).

Pour l'interpolation parabolique, trois points déterminent une parabole dont l'équation est vp(x)=a2*x²+b2*x+c2. Sur la figure 1 on a utilisé les points aux instants x=-1, x=0 et x=1 qui délimitent 2 intervalles, [-1, 0] et [0, 1]. Si la valeur de ces points est v(-1), v(0) et v(1) respectivement, on obtient les coefficients a2, b2 et c2 comme suit : $a 2 = \left(v\left(-1\right)+v\left(1\right)\right) / 2 - v \left(0\right)$ $b 2 = v \left(1\right) - v \left(0\right) - a 2$ $c 2 = v \left(0\right)$ L'obtention des coefficients a2, b2 et c2 d'une parabole nécessite 4 opérations addition et une opération multiplication ou 3 opérations addition et une opération MAC. Le calcul d'un échantillon interpolé vp(x) coûte 2 opérations addition et 3 opérations multiplication ou une opération multiplication et 2 opérations MAC.

Pour l'interpolation cubique, quatre points déterminent une courbe cubique dont l'équation est vc(x)=a3*x³+b3*x²+c3*x+d3. Sur la figure 1 on a utilisé les points aux instants x=-1, x=0, x=1 et x=2 qui délimitent 3 intervalles, [-1, 0], [0, 1] et [1, 2]. Si la valeur de ces points est v(-1), v(0), v(1) et v(2) respectivement, on obtient les coefficients a3, b3, c3 et d3 comme suit : $b 3 = \left(v\left(-1\right)+v\left(1\right)\right) / 2 - v \left(0\right)$ $a 3 = \left(v\left(-1\right)+v\left(2\right)-v\left(0\right)-v\left(1\right)-4*b3\right) / 6$ $c 3 = v \left(1\right) - v \left(0\right) - b 3 - a 3$ $d 3 = v \left(0\right)$ L'obtention des coefficients a3, b3, c3 et d3 d'une cubique nécessite 9 opérations addition et 3 opérations multiplication ou 7 opérations addition, 2 opérations MAC et une opération multiplication. Le calcul d'un échantillon interpolé vc(x) coûte 3 opérations addition et 6 opération multiplication ou en optimisant 2 opérations multiplication et 3 opérations MAC.

Pour l'interpolation d'ordre 4, 5 points déterminent une courbe d'ordre 4 dont l'équation est v4(x)=a4*x⁴+b4*x³+c4*x²+d4*x+e4. Sur la figure 1 on a utilisé les points aux instants x=-2, x=-1, x=0, x=1 et x=2 qui délimitent 4 intervalles, [-2, -1], [-1, 0], [0, 1] et [1, 2]. Si la valeur de ces points est v(-2), v(-1), v(0), v(1) et v(2) respectivement, on obtient les coefficients a4, b4, c4, d4 et e4 comme suit : $vt 1 = v \left(-2\right) + v \left(2\right) - 2 * v \left(0\right)$ $vt 2 = v \left(-1\right) + v \left(1\right) - 2 * v \left(0\right)$ $vt 3 = v \left(2\right) - v \left(-2\right)$ $vt 4 = v \left(1\right) - v \left(-1\right)$ $a 4 = \left(vt1-4*vt2\right) / 24$ $b 4 = \left(vt3-2*vt4\right) / 12$ $c 4 = \left(16*vt2-vt1\right) / 24$ $d 4 = \left(8*vt4-vt3\right) / 12$ $e 4 = v \left(0\right)$ L'obtention des coefficients a4, b4, c4, d4 et e4 d'une courbe d'ordre 4 nécessite 10 opérations addition et 10 opérations multiplication ou 6 opérations addition, 8 opérations MAC et 2 opérations multiplication. Le calcul d'un échantillon interpolé vc(x) coûte 4 opérations addition et 10 opérations multiplication ou en optimisant 3 opérations multiplication et 4 opérations MAC.

Pour calculer les coefficients d'une courbe, par exemple les coefficients a3, b3, c3 et d3 d'une courbe cubique, sans perte de généralité, il est conseillé de considérer les 4 échantillons d'entrée consécutifs comme s'ils étaient des échantillons d'indice x=-1, x=0, x=1 et x=2 pour simplifier les calculs.

Quand on effectue un ré-échantillonnage d'un signal on veut connaitre la valeur du signal entre 2 points connus du signal à ré-échantillonner, dans l'intervalle délimité par ces 2 points. Par exemple pour un sur-échantillonnage d'un facteur 2, il faut estimer la valeur du signal pour x =0.5. Pour faire cette estimation on calcule simplement une des valeurs vl(0.5), vp(0.5) ou vc(0.5).

En utilisant l'interpolation linéaire on utilise la ligne droite reliant les 2 points voisins connus (x=0 et x=1 pour calculer x=0.5, x=1 et x=2 pour calculer x=1.5).

En cas d'interpolation d'ordre 2, on a le choix entre 2 paraboles possibles car les 3 points déterminant la parabole délimitent 2 intervalles. Par exemple pour x =0.5 on peut prendre la courbe reliant des points x=-1, x=0 et x=1 ou des points x=0, x=1 et x=2. De façon expérimentale on peut vérifier que les 2 solutions donneront la même qualité. Avantageusement, pour réduire la complexité, on peut utiliser une seule parabole pour 2 intervalles ; cette simplification est utilisée par la suite lorsque l'interpolation parabolique est discutée.

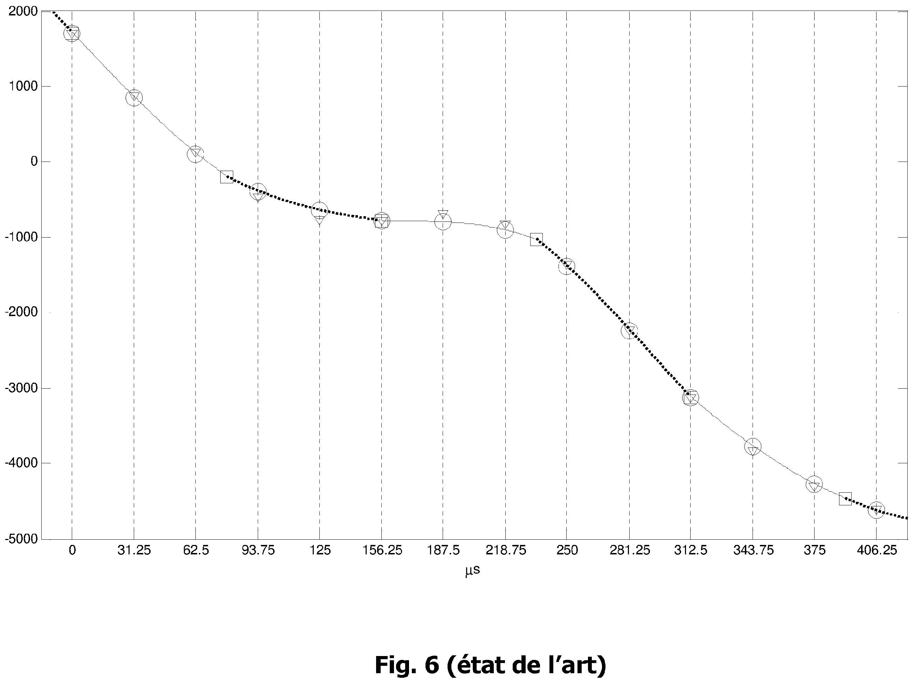

En cas d'interpolation d'ordre 3 la cubique passe par 4 échantillons d'entrée qui délimitent 3 intervalles, 2 intervalles aux extrémités et un intervalle central. En général et comme dans les résultats présentés sur la figure 6, on utilise l'intervalle central [0 , 1] pour effectuer l'interpolation à partir des points aux instants x = -1, 0, 1 et 2.

En cas d'interpolation d'ordre 4 la courbe passe par 5 échantillons d'entrée qui délimitent 4 intervalles, 2 aux extrémités et deux centraux. De façon expérimentale, on peut montrer que l'utilisation d'un des deux intervalles centraux donne le meilleur résultat, et que les 2 intervalles centraux donnent la même qualité. Comme pour le cas parabolique, on peut procéder ici aussi par groupe de 2 échantillons d'entrée.

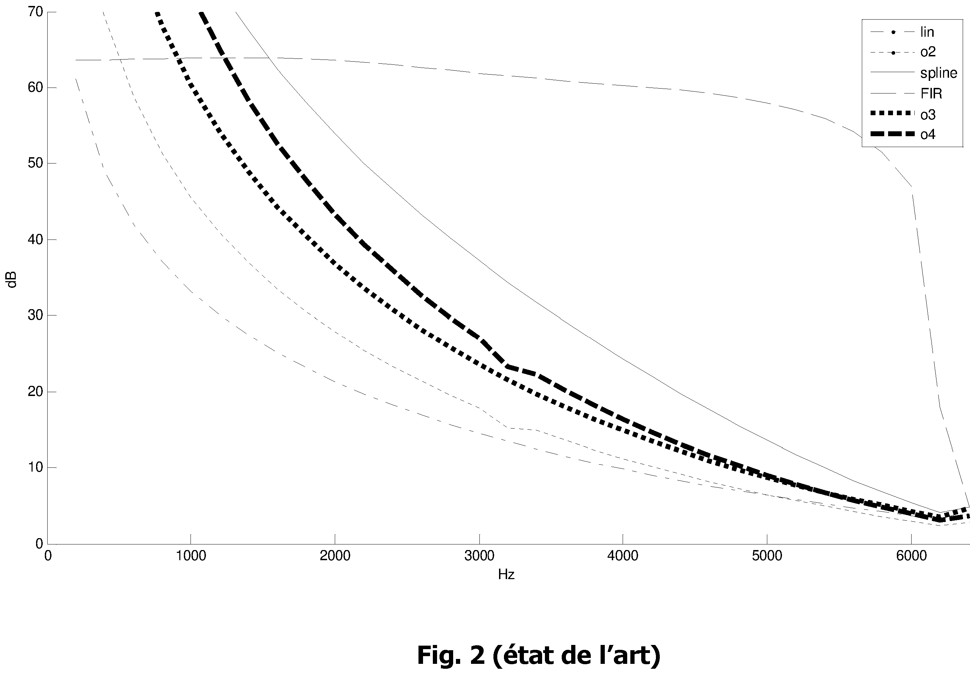

Pour comparer la performance de ces interpolations de l'état de l'art une série de sinusoïdes ayant une fréquence de 200 à 6400 Hz et un pas de 200 Hz a été générée à la fois à une fréquence d'échantillonnage de 12800 Hz et de 32000 Hz. Puis les sinusoïdes à 12800 Hz ont été sur-échantillonnées à 32 kHz et le rapport signal à bruit (RSB) a été mesuré pour chaque fréquence de sinusoïde et pour chaque méthode d'interpolation (avec compensation de retard pour le ré-échantillonnage par FIR). Il est important de remarquer ici que l'interpolation a été mise en œuvre en décalant l'instant x 0 pour le faire coïncider avec l'échantillon courant à la fréquence d'entrée ; l'interpolation se fait donc sans retard. Les échantillons au bord du signal d'entrée à ré-échantillonner, c'est-à-dire les premiers échantillons et les derniers échantillons, ont été ignorés. La **figure 2** résume les résultats obtenus avec l'interpolation linéaire ('lin'), parabolique ou d'ordre 2 ('o2', en utilisant 1 parabole pour 2 intervalles), cubique ou d'ordre 3 ('o3', en utilisant l'intervalle central), interpolation d'ordre 4 ('o4', en utilisant les 2 intervalles centraux d'une courbe d'ordre 4 pour 2 intervalles), interpolation par "spline" cubique ('spline', en utilisant la commande « spline » de Matlab) et ré-échantillonnage par filtrage FIR ('FIR', en utilisant la commande «s32= resample(s12, 5, 2, 30) » de Matlab). Les résultats montrent que le filtrage FIR donne le meilleur RSB quasi-constant pour toutes les fréquences jusqu'à 5500 Hz au prix d'une complexité plus élevée et un retard algorithmique conséquent (compensé ici en utilisant la réponse impulsionnelle du filtre FIR comme s'il s'agissait d'un filtre à phase nulle). Les différentes interpolations ont de bonnes performances pour les basses fréquences mais le RSB chute rapidement avec l'augmentation de la fréquence. Plus l'ordre de l'interpolation est élevé meilleur est le résultat, mais cette amélioration est limitée pour la deuxième moitié du spectre où la différence entre les interpolations d'ordre 3 et d'ordre 4 est peu significative et inexistante pour le dernier quart du spectre. Avec l'interpolation cubique le RSB est inférieur à 30 dB pour les fréquences supérieures à 2500 Hz, cette limite est de 2800 Hz pour l'interpolation d'ordre 4. Au prix d'une complexité plus élevée, c'est l'interpolation par "spline" cubique qui a les meilleures performances d'interpolation avec 30 dB à 3500 Hz. Dans la suite on considérera l'interpolation par FIR comme référence. On a mesuré également le RSB pour un signal de parole (par rapport au signal de référence obtenu par FIR). Les rapports signal à bruit obtenus sont de 34.7 dB avec l'interpolation linéaire, de 35.5 dB avec l'interpolation parabolique, de 38.2 dB avec l'interpolation cubique, de 37.9 dB avec l'interpolation d'ordre 4 et de 41.4 dB avec l'interpolation "spline" cubique. On peut donc conclure que l'interpolation d'ordre supérieur à 3 a peu d'intérêt, cette augmentation d'ordre n'est pas mesurable pour les signaux réels. Dans la suite, on ne considèrera pas le cas de l'interpolation d'ordre 4.

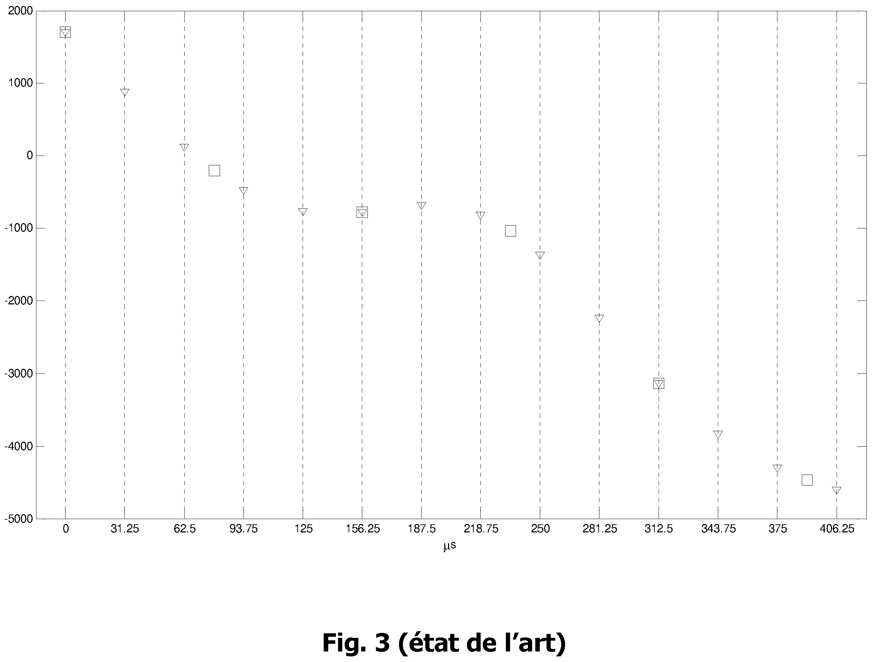

La **figure 3** illustre une interpolation de 12800 Hz à 32000Hz sur un cas réel. Les carrés représentent les échantillons du signal à 12800 Hz, les triangles, les échantillons de signal sur-échantillonné à 32000 Hz par une méthode de FIR qui donne le signal de référence sur lequel on se basera par la suite. Les lignes verticales en pointillés donnent les instants d'échantillonnage à 32 kHz. On observe que dans cet exemple pour 2 échantillons d'entrée à 12.8 kHz on obtient 5 échantillons de sortie à 32 kHz dont un est identique à un des échantillons d'entrée (cela nécessite quand même une opération de copie). Deux échantillons sont interpolés par intervalle entre les échantillons d'entrée consécutifs à 12.8 kHz. On peut ainsi estimer pour 2 échantillons d'entrée, la complexité de calcul pour les différentes interpolations, en supposant que les opérations addition, multiplication ou MAC ont toutes le même poids (ce qui est le cas pour la plupart des processeurs de traitement de signal ou DSP pour "Digital Signal Processor" en anglais) :
- Interpolation linéaire : 2 droites, 4 échantillons interpolés et une copie : 7 opérations soit 44800 opérations par seconde.
- Interpolation parabolique : 1 parabole, 4 échantillons interpolés et une copie : 17 opérations soit 108800 opérations par seconde.
- Interpolation cubique : 2 cubiques, 4 échantillons interpolés et une copie : 41 opérations soit 262400 opérations par seconde.

Ces complexités peuvent être encore réduites en tabulant les valeurs x² et x³, c'est-à-dire en les pré-calculant et en les enregistrant dans une table. Ceci est possible car on utilise toujours les mêmes indices temporels, par exemple on fait l'interpolation dans l'intervalle [0, 1]. Par exemple, lors de l'interpolation cubique et dans l'exemple de sur-échantillonnage de 12800 Hz à 32000Hz, on doit tabuler ces valeurs uniquement pour x=0.2, 0.4, 0.6 et 0.8. Ceci peut économiser une ou deux multiplications par échantillon interpolé. Ainsi pour l'interpolation parabolique la complexité est réduite à 13 opérations soit 83200 opérations par seconde, et pour l'interpolation cubique à 33 opérations soit 211200 opérations par seconde.

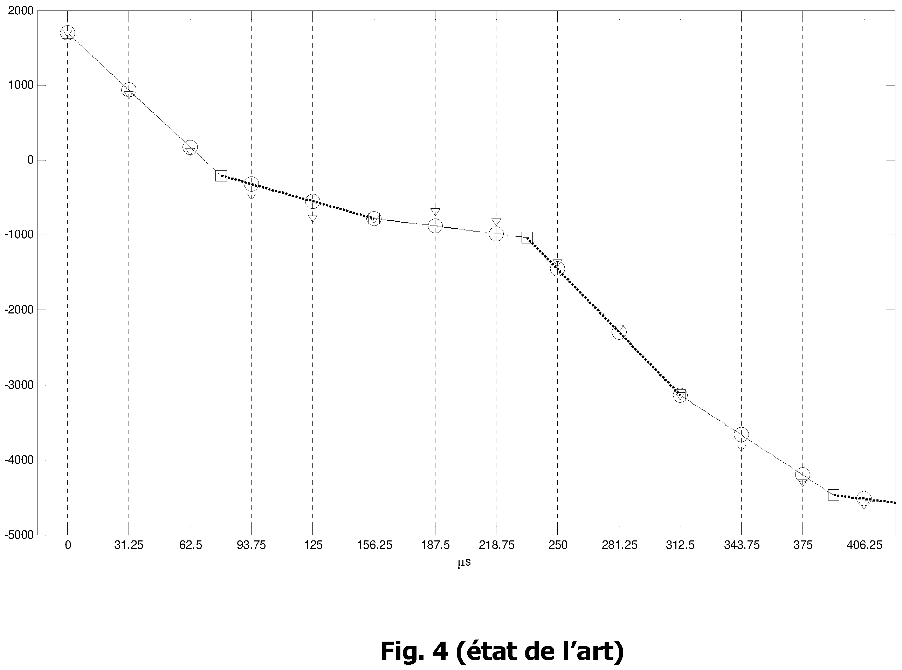

Sur la **figure 4** on a complété la figure 3 pour illustrer l'interpolation linéaire. Les échantillons du signal sur-échantillonné (marqueurs ronds) sont donnés par les intersections des droites (illustrées en trait plein et en pointillé) entre 2 échantillons d'entrée (marqueurs carrés) et des moments d'échantillonnage de sortie (traits verticaux pointillés). Par rapport au signal de référence (marqueurs triangulaires) plusieurs écarts importants peuvent être observés. On notera que les différentes droites utilisées sont représentées en alternance par un trait plein ou un trait en pointillés.

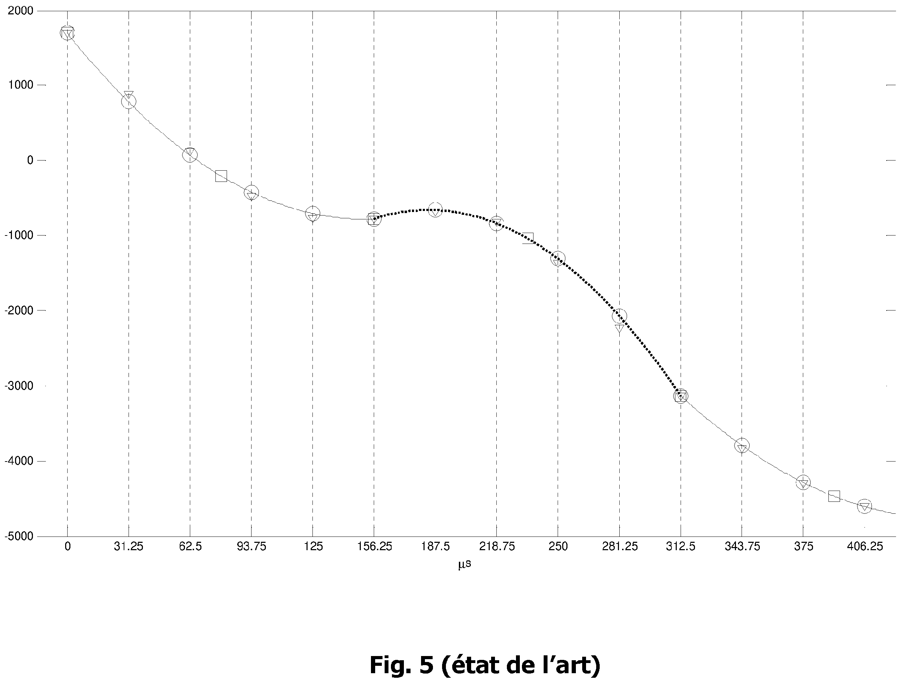

De façon analogue à la figure 4, la **figure 5** illustre l'interpolation parabolique avec une parabole calculée pour 2 intervalles. La plus grande erreur est à l'instant 281.5 µs. On notera que les différentes paraboles utilisées sont représentées en alternance par un trait plein ou un trait en pointillés.

La **figure 6** illustre l'interpolation cubique. Les échantillons interpolés illustrés par les marqueurs ronds ont été obtenus avec l'intervalle central. De nouveau on observe plusieurs écarts par rapport au signal de référence. On suppose ici que le signal d'entrée est connu en dehors du support temporel représenté sur la figure, si bien que les échantillons aux bords (ici les 2 premiers et les 2 derniers échantillons d'entrée) peuvent être utilisés pour l'interpolation. On notera que les différentes cubiques utilisées sont représentées en alternance par un trait plein ou un trait en pointillés ; on rappelle que seul l'intervalle central est utilisé.

On voit que ces interpolations sont perfectibles. On a montré que l'augmentation de l'ordre de l'interpolation au-delà de 3 n'est pas une solution intéressante. Il est connu de l'état de l'art que les "splines" d'interpolation peuvent atteindre en général de meilleures performances mais au prix d'une complexité beaucoup plus élevée.

La présente invention vient améliorer la situation de l'état de l'art.
Elle propose à cet effet, un procédé de ré-échantillonnage d'un signal audiofréquence dans un décodage de signal audiofréquence. Le procédé est tel que le ré-échantillonnage s'effectue sur un signal contenu dans une mémoire d'un filtre de ré-échantillonnage de type FIR par une méthode d'interpolation d'ordre supérieur à un, que les échantillons interpolés sont obtenus par un calcul d'une moyenne pondérée de valeurs d'interpolations possibles calculées à partir de coefficients d'une pluralité de polynômes d'interpolation d'ordre supérieur à un, les coefficients étant calculées sur une pluralité d'intervalles couvrant l'emplacement temporel de l'échantillon à interpoler, et que les échantillons interpolés complètent un signal décodé selon un mode de décodage prédictif restreint dans une trame de transition entre un décodage prédictif et un décodage par transformée avant une étape de combinaison entre des échantillons décodés selon le décodage prédictif restreint et complétés et des échantillons décodés selon un codage par transformée dans la trame de transition.

Ainsi, la moyenne des valeurs possibles d'interpolation obtenues sur plusieurs intervalles permet d'obtenir une valeur d'échantillon interpolé proche de la valeur réelle de signal. De plus, cette méthode de ré-échantillonnage est particulièrement adaptée à un vecteur de signal de faible longueur comme des mémoires de filtres.

Le ré-échantillonnage selon l'invention est adaptée à ce contexte de transition entre deux modes de codage et lorsqu'un retard dû au ré-échantillonnage peut engendrer un manque d'échantillons. L'interpolation proposée est alors efficace pour ce type de signal de faible longueur.

Les différents modes de réalisation particuliers mentionnés ci-après peuvent être ajoutés indépendamment ou en combinaison les uns avec les autres, au procédé de ré-échantillonnage décrit ci-dessus.

Dans un mode particulier de réalisation, l'interpolation est de type parabolique d'ordre 2.

Dans ce cas, les échantillons interpolés sont obtenus par un calcul d'une moyenne pondérée de valeurs d'interpolations possibles calculées sur deux intervalles couvrant l'emplacement temporel de l'échantillon à interpoler.

Cette solution donne un résultat quasi équivalent avec l'interpolation cubique simple mais est moins complexe.

Dans un mode de réalisation de l'invention, l'interpolation est de type cubique, d'ordre 3 et le nombre d'intervalles couvrant l'emplacement temporel de l'échantillon à interpoler est de 3.

Ce mode de réalisation permet d'avoir une interpolation de bonne qualité, les échantillons interpolés étant plus proches du signal de référence que ne le sont les échantillons interpolés par simple interpolation cubique obtenus uniquement avec l'intervalle central. La qualité est donc améliorée pour une complexité comparable.

Dans un mode de réalisation particulier, la moyenne pondérée est obtenue avec une même valeur de pondération pour chacune des valeurs d'interpolation possibles.

Ces valeurs de pondération permettent d'obtenir une performance toujours supérieure aux interpolations polynomiales de Lagrange, et notamment un meilleur rapport signal à bruit.

Dans une variante de réalisation, une valeur de pondération différente est appliquée pour la valeur d'interpolation calculée pour l'intervalle central des trois intervalles, pour le calcul de la moyenne pondérée.

Si l'un des poids est à valeur nulle, cette variante réduit la complexité et améliore les performances de rapport signal à bruit pour les hautes fréquences. De façon plus générale, on peut améliorer les performances pour certaines zones de fréquences selon les valeurs de pondération choisie.

Dans une autre variante de réalisation, les valeurs de pondération appliquées aux valeurs d'interpolation possibles, sont déterminées en fonction d'un critère fréquentiel de l'échantillon à interpoler.

Ceci permet d'avoir de performances meilleures de rapport signal à bruit quelque soit la fréquence du signal à interpoler.

La présente invention vise également un décodeur de signal audiofréquence comportant un dispositif de ré-échantillonnage d'un signal audiofréquence. Le décodeur est tel que le ré-échantillonnage s'effectue par une méthode d'interpolation d'ordre supérieur à un, sur un signal contenu dans une mémoire d'un filtre de ré-échantillonnage de type FIR, le dispositif de ré-échantillonnage comportant:
- un module de calcul apte à calculer des valeurs d'interpolations possibles à partir de coefficients d'une pluralité de polynômes d'interpolation d'ordre supérieur à un, les coefficients étant calculées pour une pluralité d'intervalles couvrant l'emplacement temporel d'un échantillon à interpoler; et
- un module d'obtention de l'échantillon à interpoler par calcul d'une moyenne pondérée des valeurs d'interpolations possibles issues du module de calcul ;
   le décodeur comportant en outre:
   - un module de décodage prédictif restreint apte à mettre en œuvre un décodage restreint dans une trame de transition entre un décodage prédictif et un décodage par transformée, les échantillons interpolés complétant le signal décodé restreint dans la trame de transition ; et
   - un module de combinaison apte à mettre en œuvre une étape de combinaison entre des échantillons décodés selon le décodage prédictif restreint et complétés et des échantillons décodés selon un codage par transformée dans la trame de transition.

Ce décodeur présente les mêmes avantages que le procédé décrit précédemment, qu'il met en œuvre.

L'invention vise un programme informatique comportant des instructions de code pour la mise en œuvre des étapes du procédé de ré-échantillonnage tel que décrit, lorsque ces instructions sont exécutées par un processeur.

Enfin l'invention se rapporte à un support de stockage, lisible par un processeur, intégré ou non au dispositif de ré-échantillonnage, éventuellement amovible, mémorisant un programme informatique mettant en œuvre un procédé de ré-échantillonnage tel que décrit précédemment.

D'autres caractéristiques et avantages de l'invention apparaîtront plus clairement à la lecture de la description suivante, donnée uniquement à titre d'exemple non limitatif, et faite en référence aux dessins annexés, sur lesquels :
- la figure 1, telle que décrite précédemment, illustre une comparaison entre différents types d'interpolation de l'état de l'art par une représentation de courbes polynomiales définies par des points prédéfinis aux instants représentés en abscisse;
- la figure 2, telle que décrite précédemment, illustre le résultat du rapport signal à bruit en fonction de la fréquence pour différents types d'interpolation de l'état de l'art;
- la figure 3, telle que décrite précédemment, illustre une interpolation pour un ré-échantillonnage de 12800 Hz à 32000Hz effectué par un filtre de type FIR;
- la figure 4, telle que décrite précédemment, illustre une comparaison entre les échantillons obtenus par une interpolation de type FIR et par une interpolation de type linéaire de l'état de l'art;
- la figure 5, telle que décrite précédemment, illustre une comparaison entre les échantillons obtenus par une interpolation de type FIR et par une interpolation de type parabolique de l'état de l'art;
- la figure 6, telle que décrite précédemment, illustre une comparaison entre les échantillons obtenus par une interpolation de type FIR et par une interpolation de type cubique de l'état de l'art;
- la figure 7 illustre sous forme d'organigramme, les étapes d'un procédé de ré-échantillonnage selon un mode de réalisation de l'invention;
- la figure 8 illustre un exemple de codeur de signal audio comportant un dispositif de ré-échantillonnage selon un mode de réalisation de l'invention;
- la figure 9a illustre une transition entre une trame de signal codée avec un codage prédictif et une trame codée par transformée selon une méthode de l'état de l'art;
- la figure 9b illustre une transition entre une trame de signal codée avec un codage prédictif et une trame codée par transformée utilisant un procédé de ré-échantillonnage selon un mode de réalisation de l'invention;
- la figure 10 illustre un exemple de décodeur de signal audio comportant un dispositif de ré-échantillonnage selon un mode de réalisation de l'invention;
- la figure 11 illustre un exemple de traitement des échantillons aux bords de l'intervalle à interpoler;
- la figure 12, illustre une comparaison entre les échantillons obtenus par une interpolation de type FIR, par une interpolation de type cubique de l'état de l'art et par une interpolation selon un mode de réalisation de l'invention;
- la figure 13, illustre le résultat du rapport signal à bruit en fonction de la fréquence pour différents types d'interpolation de l'état de l'art et pour l'interpolation selon un premier mode de réalisation de l'invention;
- la figure 14, illustre le résultat du rapport signal à bruit en fonction de la fréquence pour différents types d'interpolation de l'état de l'art et pour l'interpolation selon un deuxième mode de réalisation de l'invention;
- la figure 15 illustre une représentation matérielle d'un dispositif de ré-échantillonnage selon un mode de réalisation de l'invention.

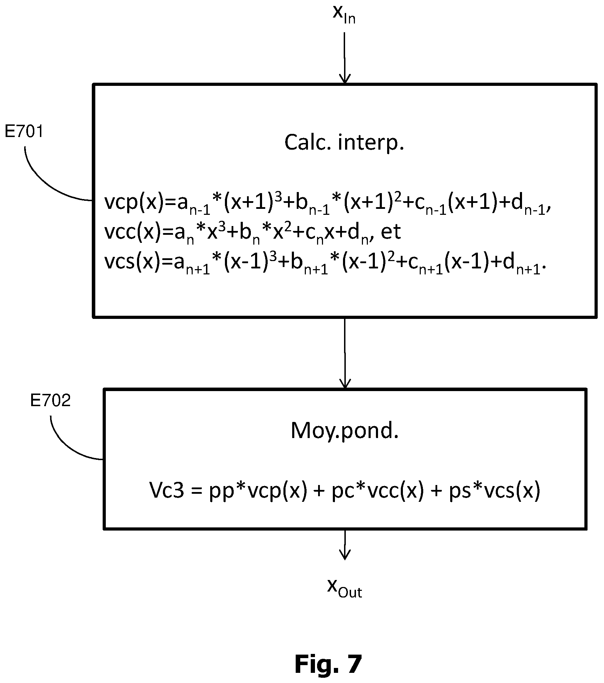

La **figure 7** illustre donc les étapes principales d'un procédé de ré-échantillonnage selon un mode de réalisation de l'invention.

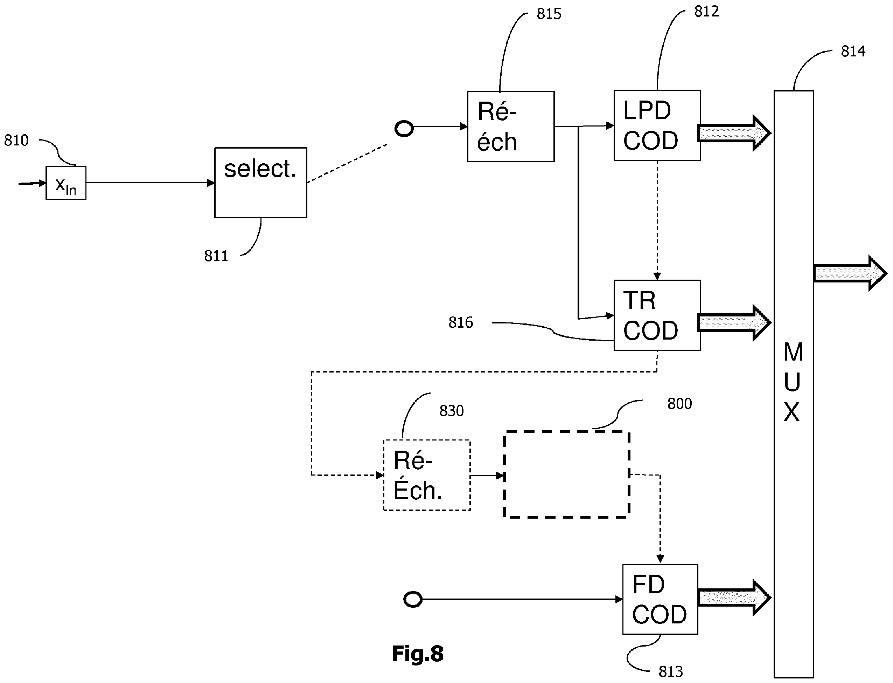

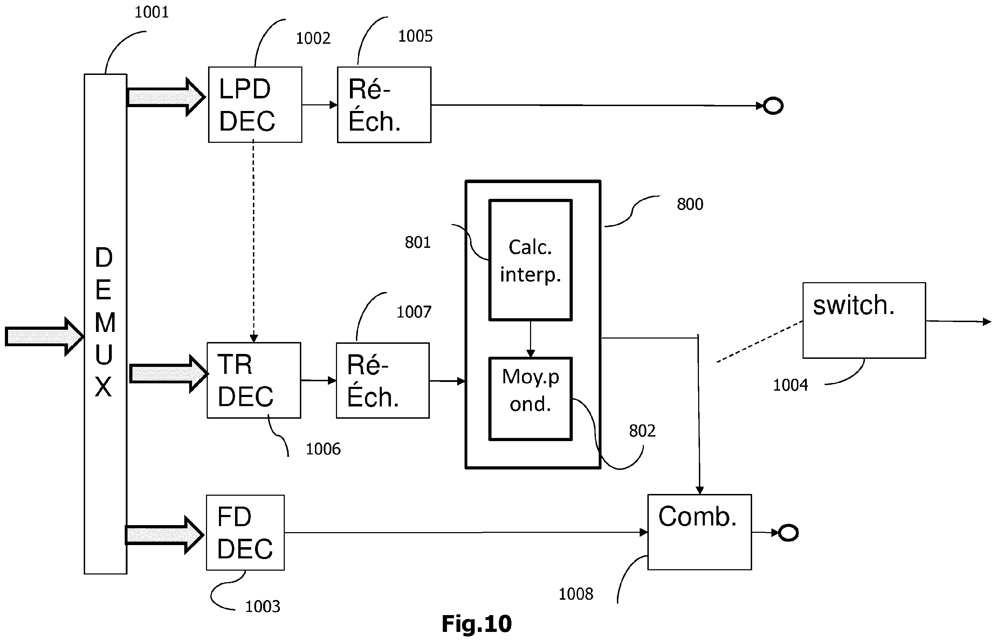

Les étapes de ce procédé sont mises en œuvre avec en entrée (x_{In}) un signal audiofréquence à la fréquence échantillonnage d'entrée f_{In}. Ce signal d'entrée peut être par exemple des vecteurs de signal de faible longueur contenus dans une mémoire de filtre de ré-échantillonnage comme décrit ultérieurement en référence aux figures 8 et 10.

Dans le mode de réalisation décrit ici, une méthode d'interpolation de type cubique, d'ordre 3 est utilisé. Un ordre différent d'interpolation peut bien sûr être utilisé, l'ordre étant cependant supérieur à un.

A l'étape E701, une interpolation cubique est utilisée non seulement sur l'intervalle central mais sur les 3 intervalles :
- l'intervalle à droite (intervalle [1, 2]) de la cubique précédente,
- l'intervalle centrale de la cubique centrale (intervalle [0, 1]) et
- l'intervalle à gauche (intervalle [-1, 0]) de la cubique suivante pour interpoler une valeur à un instant temporel x dans [0, 1].

Les trois valeurs d'interpolation possibles sont obtenues. Ceci augmente la complexité de calcul de façon limitée car les coefficients d'une cubique sont de tout de façon calculés par intervalle. Si on utilise la notation simplifiée (sans mentionner l'ordre 3) aₙ, bₙ, cₙ, dₙ pour les coefficients de la cubique dont on utilise l'intervalle central, aₙ₋₁, bₙ₋₁, cₙ₋₁, dₙ₋₁ pour les coefficients de la cubique dans l'intervalle précédent et aₙ₊₁, bₙ₊₁, cₙ₊₁, dₙ₊₁ pour les coefficients de la cubique dans l'intervalle suivant, les trois valeurs d'interpolation possible sont obtenus par : $vcp \left(x\right) = {a}_{n - 1} * {\left(x+1\right)}^{3} + {b}_{n - 1} * {\left(x+1\right)}^{2} + {c}_{n - 1} \left(x+1\right) + {d}_{n - 1} ,$ $vcc \left(x\right) = {{a}_{n}}^{∗} {x}^{3} + {{b}_{n}}^{∗} {x}^{2} + {c}_{n} x + {d}_{n} ,$ et $vcs \left(x\right) = {a}_{n + 1} * {\left(x-1\right)}^{3} + {b}_{n + 1} * {\left(x-1\right)}^{2} + {c}_{n + 1} \left(x-1\right) + {d}_{n + 1} .$

De nouveau, les valeurs (x+1)³, (x+1)², x³, x², (x-1)³ et (x-1)² peuvent être tabulées pour réduire la complexité.

Ainsi, l'étape E701 calcule des valeurs d'interpolations possibles sur une pluralité d'intervalles couvrant l'emplacement temporel de l'échantillon à interpoler (dans l'exemple donné ici, l'ordre d'interpolation est de 3).

A l'étape E702, une moyenne pondérée des trois valeurs interpolées possibles est calculée pour obtenir l'échantillon à interpoler. Le signal de sortie ré-échantillonné à la fréquence de sortie f_{Out} , par l'interpolation telle que décrite ici, est alors obtenu (x_{Out})

Ainsi, la valeur de l'échantillon interpolé à l'instant x (par rapport à la cubique centrale donc x dans [0, 1]) est obtenu par la somme pondérée de ces 3 valeurs : $Vc 3 = pp * vcp \left(x\right) + pc * vcc \left(x\right) + ps * vcs \left(x\right)$ où dans un exemple de réalisation, les coefficients de pondération pp, pc et ps sont dans l'intervalle ]0, 1[, avec pp+pc+ps = 1 et en général pp=ps=(1-pc)/2.

Par exemple on peut choisir pp = pc = ps = 1/3. Dans ce cas la division par 3 peut être intégrée dans les coefficients des cubiques.

On notera que l'invention illustrée à la figure 7 ne tient pas compte des échantillons au bord du buffer d'entrée x_{In}(n), n=0,...,L-1. Comme expliqué plus loin dans l'invention :
On suppose que les échantillons au début du buffer de sortie (entre les deux premiers échantillons x_{In}(n), n=0,1) peuvent être interpolés en connaissant les valeurs du signal passé aux instants précédant n=-1,-2 qui sont nécessaires pour déterminer les premiers coefficients a₋₁, b₋₁, c₋₁, d₋₁, a₀, b₀, c₀ et d₀, ; ces échantillons passés peuvent être intégrés au buffer d'entrée ou utilisés séparément dans la réalisation du bloc E701.

Les échantillons à la fin du buffer de sortie (entre et après les deux derniers échantillons, x_{In}(n), n=L-2,L-1) ne peuvent pas être directement interpolés selon les blocs E701 et E702 car on ne dispose pas en général du signal futur, correspondant aux instants n=L, L+1 qui sont nécessaires pour déterminer les derniers coefficients a_{L-1}, b_{L-1}, c_{L-1}, d_{L-1}, a_{L}, b_{L}, c_{L} et d_{L},. Différentes variantes pour traiter les échantillons aux bords sont décrites plus loin.

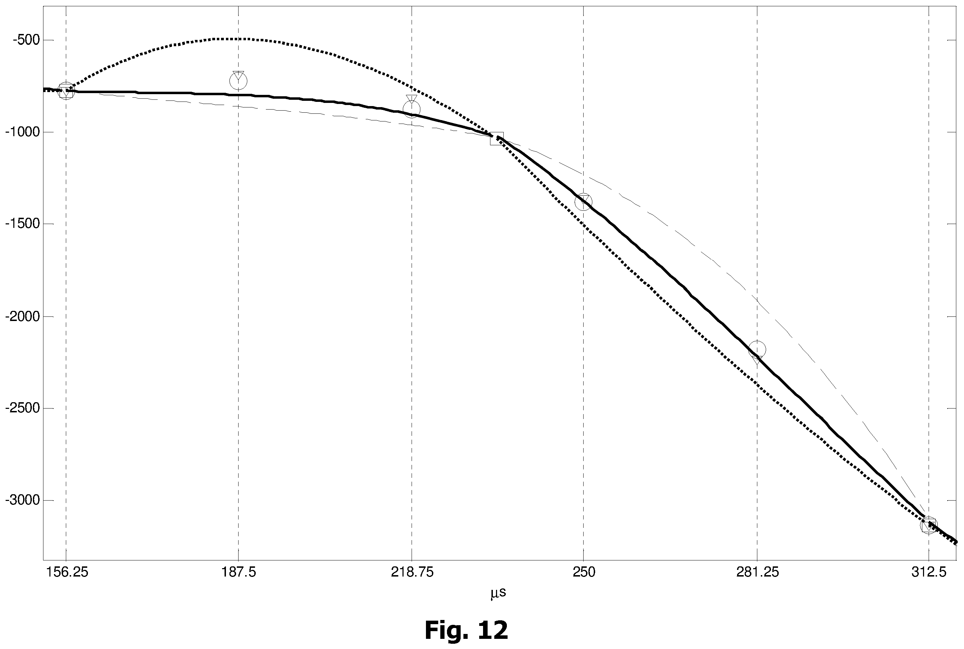

Les échantillons ainsi interpolés avec pp = pc = ps = 1/3 sont illustrés sur la **figure 12** par les marqueurs ronds. On peut remarquer que ces échantillons interpolés sont plus proches du signal de référence que ne l'étaient les échantillons interpolés par simple interpolation cubique (voir intersection de la ligne continue et les pointillés verticaux) obtenus avec l'intervalle central illustrés à la figure 6.

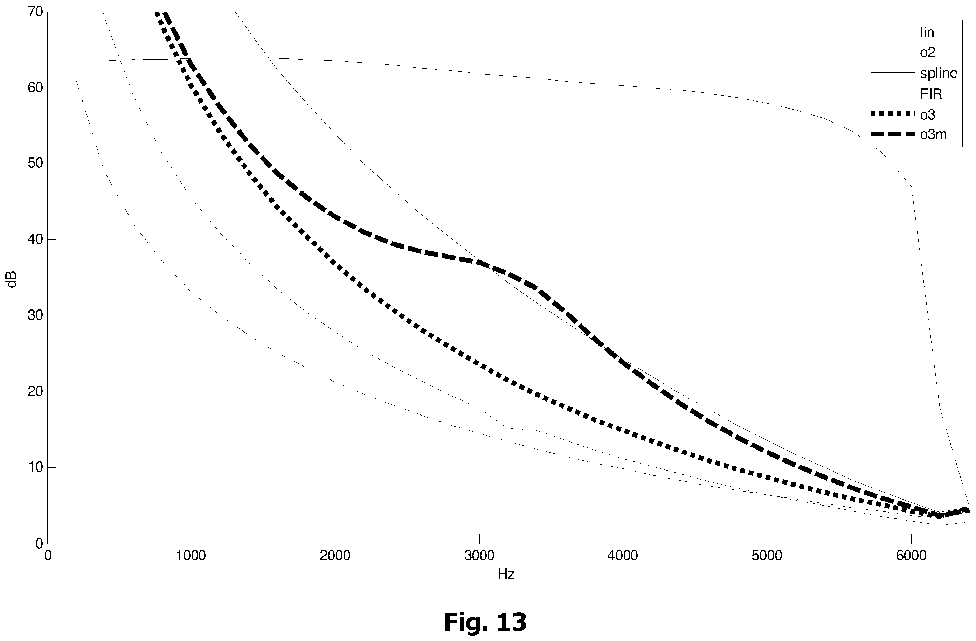

La **figure 13** reprend les éléments de la figure 2 et est complétée par la courbe ('o3m') correspondant à l'interpolation telle que décrite par le procédé de la figure 7 selon l'invention. On peut voir que l'interpolation proposée a une performance toujours supérieure à l'interpolation cubique simple, surtout dans les zones de fréquence où le RSB de l'interpolation simple devient critique, au-dessus de 2500 Hz. Cette augmentation du RSB atteint même 14 dB autour de fréquence de 3400 Hz. Avec la méthode d'interpolation selon l'invention, la limite de 30 dB est à 3600 Hz qui est même meilleure que celle de l'interpolation par "spline" cubique. La complexité de l'interpolation proposée pour le cas de l'exemple utilisé du ré-échantillonnage de 12800 Hz à 32000 Hz est de 60 opérations par groupe de 2 échantillons d'entrée soit 384000 opération par seconde.

Avec la solution selon l'invention le RSB pour le signal de parole est de 40 dB. Pour rappel, les RSBs obtenus étaient de 38.2 dB avec l'interpolation cubique connue de l'état de l'art et de 41.4 dB avec l'interpolation par "spline" cubique. On voit que l'interpolation proposée donne un meilleur RSB par rapport aux interpolations polynomiales de Lagrange.

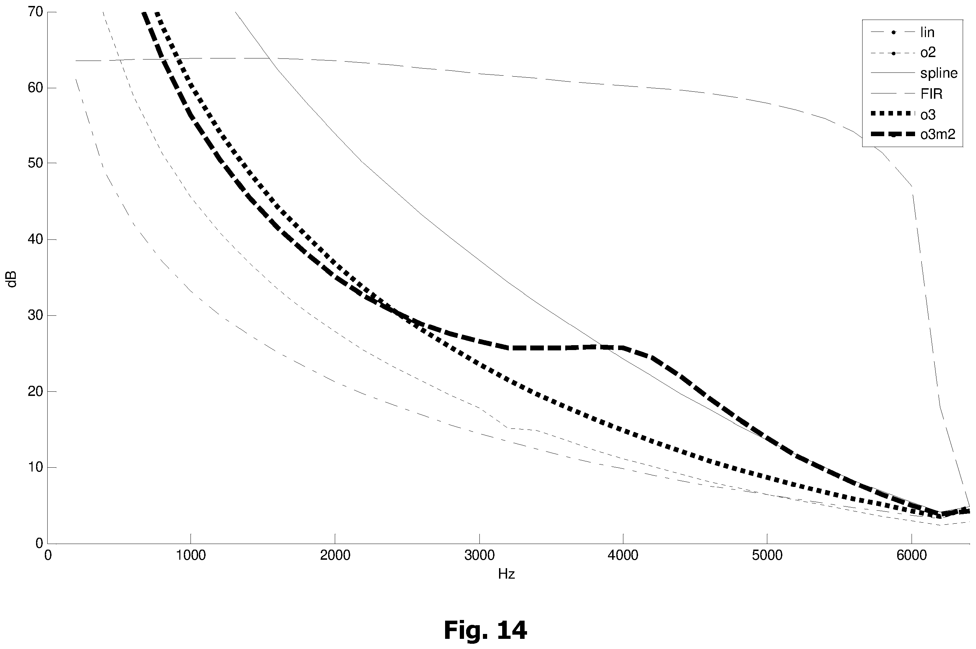

Dans une variante de l'invention les poids (pp, pc, ps) sont fixés à d'autres valeurs prédéterminées. Dans un autre exemple de réalisation, on choisit pp = ps = 0.5 et pc = 0, ce qui revient à utiliser la moyenne des valeurs interpolées à partir des 2 intervalles extrêmes. Ceci réduit le nombre d'opération à 47 (soit 300800 opération par seconde) tout en ayant une performance nettement supérieure à l'interpolation cubique simple (de Lagrange). Le RSB obtenu pour le signal de test réel est 40.4 dB. Cette solution a des performances qui sont moins bonnes pour les basses fréquences mais meilleures pour les hautes fréquences que la solution à trois poids identiques, comme le montre la **figure 14** (courbe 'o3m2').

Dans une autre variante de l'invention, on pourra également utiliser des poids (pp, pc, ps) variables selon un critère. Par exemple si le signal à interpoler contient majoritairement des basses fréquences, on utilisera la première solution proposée (pp = pc = ps = 1/3), sinon la deuxième (pp = ps = 0.5 et pc = 0).

Le principe de l'invention est généralisable pour les interpolations d'ordre différent de 3. Par exemple dans le cas d'une interpolation parabolique, on peut prendre la moyenne des 2 valeurs données par des 2 paraboles possibles.

Dans ce cas, les échantillons interpolés sont obtenus par un calcul d'une moyenne pondérée de valeurs d'interpolations possibles calculées sur deux intervalles de valeurs couvrant l'emplacement temporel de l'échantillon à interpoler.

Cette solution donne un résultat quasi équivalent avec l'interpolation cubique simple où seul l'intervalle central est utilisé.

La **figure 8** illustre un exemple de codeur audio comportant dans un décodeur local un dispositif de ré-échantillonnage selon un mode de réalisation de l'invention.

Dans ce mode de réalisation, on s'intéresse au codage unifié des signaux de parole, de musique et de contenu mixte, par le biais de techniques multi-modes alternant au moins deux modes de codage, et dont le retard algorithmique est adapté aux applications conversationnelles (typiquement ≤32 ms).
Parmi ces techniques de codage unifié, on peut citer des codeurs/décodeurs (codecs) de l'état de l'art, comme le codec AMR-WB+ ou plus récemment le Codec MPEG USAC (pour "Unified Speech Audio Coding"). Les applications visées par ces codecs ne sont pas conversationnelles, mais correspondent à des services de diffusion et stockage, sans contraintes fortes sur le retard algorithmique. Le principe du codage unifié est d'alterner entre au moins deux modes de codage:
- Pour les signaux de type parole: mode temporel noté ici **LPD** (pour "Linear Predictive Domain" en anglais) en général de type CELP (pour "Coded excitation Linear Prediction"
- Pour les signaux de type musique: mode fréquentiel noté ici **FD** (pour "Frequency Domain" en anglais) avec une transformée en général de type MDCT (pour "Modified Discrete Cosine transform")
On rappelle ci-dessous les principes des codages CELP et MDCT.

D'un côté, le codage CELP - dont sa variante ACELP - est un codage prédictif fondé sur le modèle source-filtre. Le filtre correspond en général à un filtre tout-pôle de fonction de transfert 1/*A*(*z*) obtenu par prédiction linéaire (LPC pour Linear Predictive Coding). En pratique la synthèse utilise la version quantifiée, 1 / *Â*(*z*), du filtre 1 / *A*(*z*) . La source - c'est-à-dire l'excitation du filtre linéaire prédictif 1/ *Â*(*z*) - est en général la combinaison d'une excitation obtenue par prédiction long-terme modélisant la vibration des cordes vocales, et d'une excitation stochastique (ou innovation) décrite sous la forme de codes algébriques (ACELP), de dictionnaires de bruit, etc. La recherche de l'excitation "optimale" est réalisée par minimisation d'un critère d'erreur quadratique dans le domaine du signal pondéré par un filtre de fonction de transfert *W*(*z*) en général dérivée du filtre de prédiction linéaire *A*(*z*), de la forme *M*(*z*)= *A*(*z*/*γ1*)/*A*(*z*/*γ2*) ou *A*(*z*/*γ1*)/(*1-αz⁻¹*)*.*
D'un autre côté, le codage par transformée MDCT analyse le signal d'entrée avec une transformation temps/fréquences comprenant en général différentes étapes:
1. Pondération du signal par une fenêtre appelé ici "fenêtre MDCT"
2. Repliement temporel (ou time-domain aliasing en anglais) pour former un bloc réduit (dans sa formule classique de longueur divisée par 2)
3. Transformation DCT ("Discrete Cosine Transform") du bloc réduit
   Le fenêtrage MDCT peut être adaptatif et les coefficients MDCT peuvent être quantifiés par diverses méthodes selon une allocation des bits (par exemple par sous-bandes fréquentielles).
Dans les codecs utilisant au moins deux modes de codages, les transitions entre modes LPD et FD sont cruciales pour assurer une qualité suffisante sans défaut de commutation, sachant que les modes FD et LPD sont de nature différentes - l'un repose sur un codage par transformée avec recouvrement, tandis que l'autre utilise un codage linéaire prédictif avec blocs rectangulaires et des mémoires de filtres mises à jour à chaque trame.

Pour le codeur illustré à la figure 8, le procédé de ré-échantillonnage décrit en référence à la figure 7 est mis en œuvre dans le dispositif de ré-échantillonnage d'un décodeur local (optionnel) pour effectuer l'interpolation polynomiale selon l'invention de façon à améliorer la qualité de la commutation dans le cas d'une transition d'un mode LPD à un mode FD. Le décodeur associé et le bloc 800 étant décrits plus loin en référence à la figure 10.

Dans ce mode de réalisation illustré à la figure 8, on considère le cas d'un codage d'un signal d'entrée échantillonné à la fréquence fs = 16, 32 ou 48 kHz (bloc 810) qui fonctionne par trames de 20 ms. Ce codeur traite des signaux audio (mono) et offre plusieurs débits (par exemple des débits fixes de 7.2 à 128 kbit/s). Le codeur utilise au moins deux modes de codage sélectionnés par le module de sélection 811, dont
- un mode LPD (unité de codage 812) ayant deux fréquences d'échantillonnage interne fixée à 12.8 et 16 kHz (selon le débit) qui requièrent d'utiliser un échantillonnage de la fréquence d'entrée fs à la fréquence interne de 12.8 ou 16 kHz (bloc 815)
- un mode FD (unité de codage 813) fonctionnant à la fréquence du signal d'entrée fs
Le train binaire pour chaque trame d'entrée de 20 ms est multiplexé par le module de multiplexage 814.

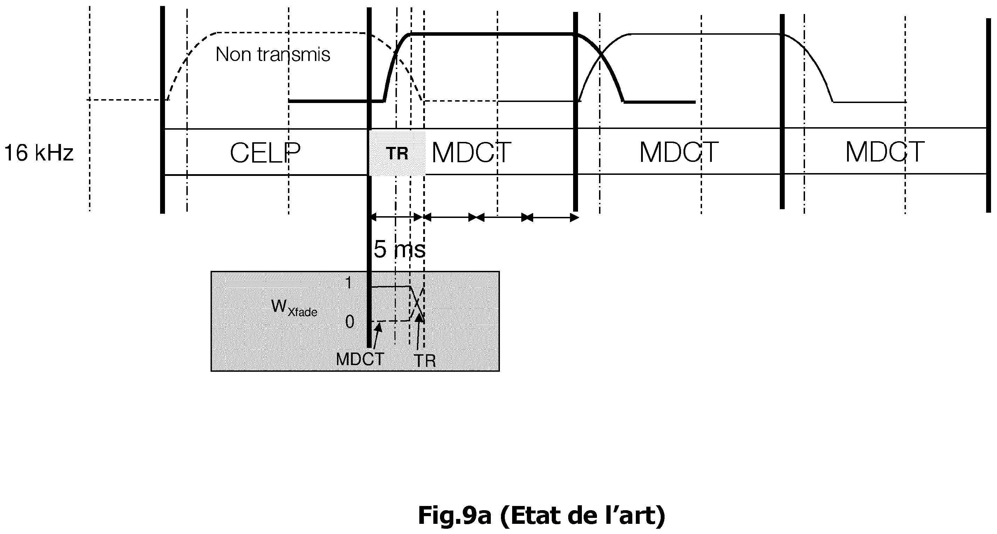

Le cas d'une transition d'un codage LPD à FD est décrit par exemple dans la demande de brevet Européenne publiée EP 2656343 incorporée ici par référence. Dans ce cas, comme illustré à la **figure 9a** où fs=16 kHz, le signal n'ayant pas été codé par le mode FD dans la trame précédente (trame codée selon le mode CELP), la mémoire de codage MDCT n'est pas disponible pour la trame courante à décoder. Au décodeur (local ou distant) il est nécessaire de générer un signal complémentaire pour la zone grisée « TR » au début de la trame courante de type FD. Ce signal complémentaire est nécessaire pour pouvoir faire une « jonction » entre les signaux décodés par les modes successifs LPD et FD ; ce signal complémentaire vient donc combler un « trou » (gap en anglais). On notera que le signal complémentaire doit être suffisamment long pour permettre un fondu enchaîné afin de limiter les défauts de transition d'un mode à l'autre.

On reprend ici le même principe de prolongation du signal en effectuant un codage LPD restreint simplifié comme décrit dans la demande EP 2656343 pour combler ce signal manquant (zone notée TR) dans la trame de transition de type FD qui suit une trame LPD ; on notera que la fenêtre MDCT illustrée ici pourra être modifiée dans des variantes de l'invention sans changer le principe de l'invention ; en particulier la fenêtre MDCT dans la trame de transition pourra être différente de la (des) fenêtre(s) MDCT utilisée(s) « normalement » dans le mode de codage FD quand la trame courante n'est pas une trame de transition de LPD à FD.

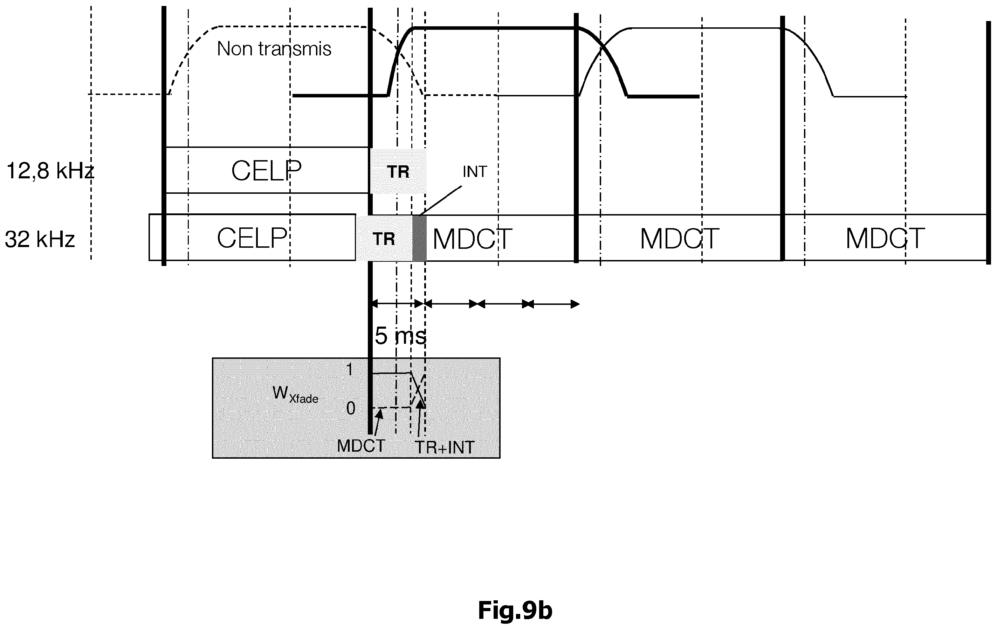

Cependant, dans le codeur illustré à la figure 8, le signal à l'entrée et à la sortie du codage/décodage LPD restreint (bloc 816) est à la fréquence 12.8 ou 16 kHz (selon le débit) ; en cas de décodage local, le signal décodé à 12.8 ou 16 kHz doit être en général ré-échantillonné à la fréquence fs avant de le combiner (par fondu enchaîné) avec le signal en sortie du codage/décodage de type FD (bloc 813) dans la trame de transition, le principe de ce fondu enchaîné étant décrit dans la demande de brevet EP 2656343. La **figure 9b** illustre un tel cas, où la fréquence du codeur LPD est de 12800 Hz et fs=32000 Hz. Le même principe s'applique lorsque la fréquence du codeur LPD est de 16000 Hz.

On suppose ici que le ré-échantillonnage de 12.8 ou 16 kHz à fs du bloc de ré-échantillonnage 830, est effectué par filtrage FIR polyphase avec une mémoire de filtre (appelée mem). Cette mémoire stocke les derniers échantillons de la trame précédente du signal décodé par mode LPD ou TR à la fréquence 12.8 ou 16 kHz. La longueur de cette mémoire correspond au retard du filtrage FIR. A cause de ce retard de ré-échantillonnage le signal à la fréquence fs, ici 32 kHz, (issu du ré-échantillonnage) est retardé. Ce ré-échantillonnage est problématique car il « agrandit » le trou à combler entre les modes LPD et FD dans la trame de transition. Il manque donc des échantillons pour mettre en oeuvre correctement le fondu enchainé entre le signal LPD ré-échantillonné à la fréquence fs et le signal décodé FD. Les derniers échantillons d'entrée à 12800 ou 16000 Hz sont cependant mémorisés à l'étape de ré-échantillonnage du bloc 830. Ces échantillons mémorisés correspondent temporellement aux échantillons manquants à 32 kHz (zone grisé foncé sur la figure 9b, marqué « INT ») liés au retard de filtrage FIR.

L'interpolation selon l'invention est utilisée dans ce mode de réalisation pour ré-échantillonner le signal contenu dans la mémoire du filtre de ré-échantillonnage (mem) afin de prolonger le signal issu du codage LPD (bloc 816) simplifié au début de la trame de transition et ainsi obtenir à 32 kHz les échantillons manquants pour pouvoir faire le fondu enchainé entre la synthèse LPD et la synthèse FD.

Le décodeur illustré à la **figure 10** est un décodeur de signaux audio (mono), multi-débits (avec des débits fixes de 7.2 à 128 kbit/s) fonctionnant aux fréquences d'échantillonnage de sortie fs de 16, 32 ou 48 kHz.

En fonction de la trame reçue et dé-multiplexée (bloc 1001), la sortie est commutée (1004) entre la sortie d'un décodeur temporel (LPD DEC) de type CELP (1002) utilisant une prédiction linéaire et un décodeur fréquentiel (FD DEC, 1003). On notera que la sortie du décodeur LPD est ré-échantillonnée de la fréquence interne 12.8 ou 16 kHz à la fréquence de sortie fs par un module de ré-échantillonnage 1005, par exemple de type FIR.

On reprend ici le même principe de prolongation du signal en effectuant un décodage LPD restreint simplifié (bloc 1006) comme décrit dans la demande EP 2656343 pour combler ce signal manquant (zone notée TR) dans la trame de transition de type FD qui suit une trame LPD.

Dans le décodeur illustré ici à la figure 10, le signal à l'entrée et à la sortie du décodage LPD restreint (bloc 1006) est à la fréquence 12.8 ou 16 kHz (selon le débit) et il doit être en général ré-échantillonné à la fréquence fs (par le bloc de ré-échantillonnage 1007) avant de le combiner (par fondu enchaîné) par le module 1008 avec le signal en sortie du décodage de type FD (bloc 1003) dans la trame de transition selon le principe décrit dans la demande de brevet EP 2656343. La **figure 9b** illustre un tel cas, où la fréquence du codeur LPD est de 12800 Hz et fs=32000 Hz sans perte de généralité.

On suppose ici que le ré-échantillonnage de 12.8 ou 16 kHz à fs du bloc de ré-échantillonnage 1007, est effectué par filtrage FIR polyphase avec une mémoire de filtre (appelée mem). Cette mémoire stocke les derniers échantillons de la trame précédente du signal décodé par mode LPD ou TR à la fréquence 12.8 ou 16 kHz. La longueur de cette mémoire correspond au retard du filtrage FIR. A cause de ce retard de ré-échantillonnage le signal à la fréquence fs, ici 32 kHz, (issu du ré-échantillonnage) est retardé. Ce ré-échantillonnage est problématique car il « agrandit » le trou à combler entre les modes LPD et FD dans la trame de transition. Il manque donc des échantillons pour mettre en œuvre correctement le fondu enchainé entre le signal LPD ré-échantillonné à la fréquence fs et le signal décodé FD. Les derniers échantillons d'entrée à 12800 ou 16000 Hz sont cependant mémorisés à l'étape de ré-échantillonnage du bloc 1007. Ces échantillons mémorisés correspondent temporellement aux échantillons manquants à 32 kHz (zone grisé foncé sur la figure 9b, marqué « INT ») liés au retard de filtrage FIR.

L'interpolation selon l'invention est utilisée dans ce mode de réalisation pour ré-échantillonner le signal contenu dans la mémoire du filtre de ré-échantillonnage (mem) afin de prolonger le signal issu du décodage LPD (bloc 1006) restreint simplifié au début de la trame de transition et ainsi obtenir à 32 kHz les échantillons manquants pour pouvoir faire le fondu enchainé entre la synthèse LPD et la synthèse FD.

Pour ré-échantillonner le signal (mem) contenu dans la mémoire du filtre de ré-échantillonnage 1007, le dispositif de ré-échantillonnage 800 selon l'invention, effectue une interpolation d'ordre supérieur à un et comporte un module 801 de calcul de valeurs d'interpolations possibles pour une pluralité d'intervalles couvrant l'emplacement temporel d'un échantillon à interpoler. Ces valeurs d'interpolations possibles sont calculées par exemple comme décrit en référence à la figure 7 pour une interpolation d'ordre 3.

Le dispositif de ré-échantillonnage comporte également un module 802 d'obtention des échantillons à interpoler par calcul d'une moyenne pondérée des valeurs d'interpolations possibles issues du module de calcul 801.

Le signal ainsi ré-échantillonné peut être combiné en 1008 au signal issu du codage FD du module 1003 par un fondu enchainé tel que décrit dans la demande de brevet EP 2656343.

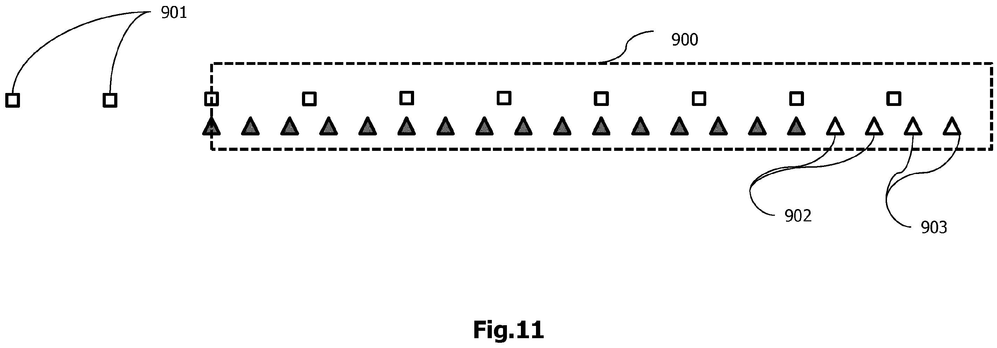

Il faut aussi remarquer qu'avec l'interpolation proposée selon l'invention on ne peut pas couvrir le support temporel entier de la mémoire de filtre (mem), comme cela est illustré sur la **figure 11****.** Sur cette figure, pour simplifier l'illustration on suppose une mémoire de filtre de 8 échantillons à 12800 Hz symbolisés par les symboles carrés. La longueur typique d'une telle mémoire est de 12 échantillons à 12800 Hz ou de 15 échantillons à 16000 Hz. Sur la figure 11, le support temporel de la mémoire est délimité par le rectangle en trait discontinu 900. Les échantillons de sortie à 32000 Hz sont symbolisés par les triangles, sur le support temporel donné il y a 8*5/2 = 20 triangles. On suppose aussi que les 2 échantillons d'entrée passés sont disponibles également (carrés 901 sur la figure), ce qui est le cas ici car ils correspondent au signal décodé dans la zone TR de transition (codage LPD simplifié). Ainsi 16 échantillons de sortie (triangles pleins sur la figure) sur 20 possibles peuvent être interpolés selon le procédé de l'invention. Les 2 échantillons de sortie suivants (triangles 902) peuvent être interpolés soit en utilisant l'intervalle extrême à droite, soit selon une interpolation parabolique sur les 3 derniers échantillons d'entrée, soit par interpolation linéaire sur les 2 derniers échantillons d'entrée. Les deux derniers échantillons de sortie du support temporel (triangles 903) doivent être extrapolés, soit en utilisant la prolongation de la dernière cubique, parabole ou droite, soit en répétant la valeur du dernier échantillon interpolé à 32 kHz ou la valeur du dernier échantillon d'entrée à 12.8kHz.

Dans le mode de réalisation privilégié, on utilise l'intervalle extrême à droite de la dernière cubique pour l'interpolation entre les 2 derniers échantillons d'entrée (triangles noirs vides) et on répète le dernier échantillon interpolé pour les échantillons extrapolés (triangles 903).

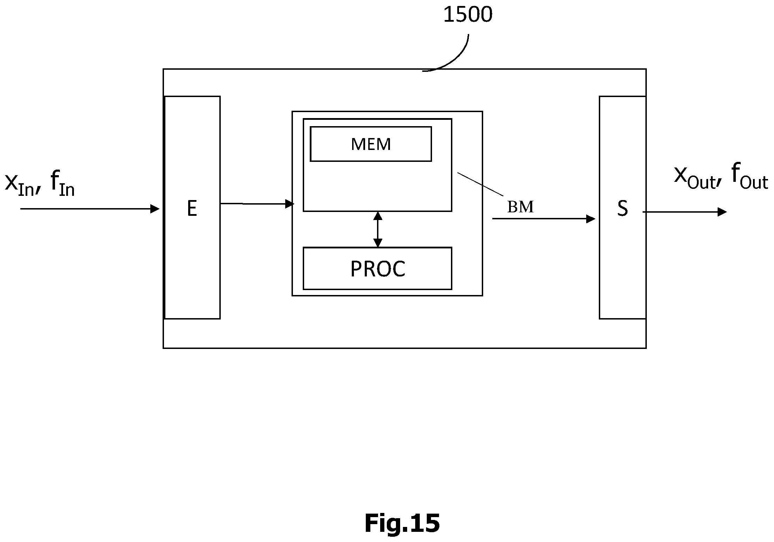

La **figure 15** représente un exemple de réalisation matérielle d'un dispositif de ré-échantillonnage 1500 selon l'invention. Celui-ci peut faire partie intégrante d'un codeur, décodeur de signal audiofréquence ou d'un équipement recevant des signaux audiofréquences.

Ce type de dispositif comporte un processeur PROC coopérant avec un bloc mémoire BM comportant une mémoire de stockage et/ou de travail MEM.
Un tel dispositif comporte un module d'entrée E apte à recevoir des trames de signal audio x_{In} à une fréquence d'échantillonnage f_{In}. Ces trames de signaux audio sont par exemple un signal contenu dans une mémoire d'un filtre de ré-échantillonnage.

Il comporte un module de sortie S apte à transmettre le signal audio fréquence ré-échantillonné x_{Out} à la fréquence d'échantillonnage de f_{Out}.

Le bloc mémoire peut avantageusement comporter un programme informatique comportant des instructions de code pour la mise en œuvre des étapes du procédé de ré-échantillonnage au sens de l'invention, lorsque ces instructions sont exécutées par le processeur PROC, et notamment l'obtention d'échantillons interpolés par un calcul d'une moyenne pondérée de valeurs d'interpolations possibles calculées sur une pluralité d'intervalles couvrant l'emplacement temporel de l'échantillon à interpoler.

Typiquement, la description de la figure 7 reprend les étapes d'un algorithme d'un tel programme informatique. Le programme informatique peut également être stocké sur un support mémoire lisible par un lecteur du dispositif ou téléchargeable dans l'espace mémoire de celui-ci.

La mémoire MEM enregistre de manière générale, toutes les données nécessaires à la mise en œuvre du procédé.

## Revendications

1. Procédé de ré-échantillonnage d'un signal audiofréquence dans un décodage de signal audiofréquence, **caractérisé en ce que** le ré-échantillonnage s'effectue sur un signal contenu dans une mémoire d'un filtre de ré-échantillonnage de type FIR par une méthode d'interpolation d'ordre supérieur à un, **en ce que** les échantillons interpolés sont obtenus par un calcul d'une moyenne pondérée (802) de valeurs d'interpolations possibles calculées à partir de coefficients d'une pluralité de polynômes d'interpolation d'ordre supérieur à un (801), les coefficients étant calculés sur une pluralité d'intervalles couvrant l'emplacement temporel de l'échantillon à interpoler, et **en ce que** les échantillons interpolés complètent un signal décodé selon un mode de décodage prédictif restreint (1006) dans une trame de transition entre un décodage prédictif et un décodage par transformée avant une étape de combinaison (1008) entre des échantillons décodés selon le décodage prédictif restreint et complétés et des échantillons décodés selon un décodage par transformée (1003) dans la trame de transition.

2. Procédé selon la revendication 1, **caractérisé en ce que** l'interpolation est de type parabolique d'ordre 2.

3. Procédé selon la revendication 1, **caractérisé en ce que** l'interpolation est de type cubique, d'ordre 3 et **en ce que** le nombre d'intervalles couvrant l'emplacement temporel de l'échantillon à interpoler est de 3.

4. Procédé selon l'une des revendications 1 à 3, **caractérisé en ce que** la moyenne pondérée est obtenue avec une même valeur de pondération pour chacune des valeurs d'interpolation possibles.

5. Procédé selon la revendication 3, **caractérisé en ce qu'**une valeur de pondération différente est appliquée pour la valeur d'interpolation calculée pour l'intervalle central des trois intervalles, pour le calcul de la moyenne pondérée.

6. Procédé selon l'une des revendications 1 à 3, **caractérisé en ce que** les valeurs de pondération appliquées aux valeurs d'interpolation possibles, sont déterminées en fonction un critère fréquentiel de l'échantillon à interpoler.

7. Décodeur de signal audiofréquence comportant un dispositif de ré-échantillonnage (800) d'un signal audiofréquence, **caractérisé en ce que** le ré-échantillonnage s'effectue par une méthode d'interpolation d'ordre supérieur à un, sur un signal contenu dans une mémoire d'un filtre de ré-échantillonnage de type FIR, le dispositif de ré-échantillonnage comportant:
- un module de calcul (801) apte à calculer des valeurs d'interpolations possibles à partir de coefficients d'une pluralité de polynômes d'interpolation d'ordre supérieur à un, les coefficients étant calculés pour une pluralité d'intervalles couvrant l'emplacement temporel d'un échantillon à interpoler; et
- un module d'obtention (802) de l'échantillon à interpoler par calcul d'une moyenne pondérée des valeurs d'interpolations possibles issues du module de calcul ; le décodeur comportant en outre:
- un module de décodage prédictif restreint (1006) apte à mettre en œuvre un décodage restreint dans une trame de transition entre un décodage prédictif et un décodage par transformée, les échantillons interpolés complétant le signal décodé restreint dans la trame de transition ; et
- un module de combinaison (1008) apte à mettre en œuvre une étape de combinaison entre des échantillons décodés selon le décodage prédictif restreint et complétés et des échantillons décodés selon un décodage par transformée dans la trame de transition.

8. Programme informatique comportant des instructions de code pour la mise en œuvre des étapes du procédé de ré-échantillonnage selon l'une des revendications 1 à 6, lorsque ces instructions sont exécutées par un processeur.

9. Support de stockage lisible par un processeur, sur lequel est stocké un programme informatique comprenant des instructions de code pour l'exécution des étapes du procédé de ré-échantillonnage selon l'une des revendications 1 à 6.

## Patentansprüche

1. Verfahren zum Neuabtasten eines Audiofrequenzsignals bei einer Audiofrequenzsignal-Decodierung, **dadurch gekennzeichnet, dass** das Neuabtasten an einem Signal, das in einem Speicher eines Neuabtastfilters vom Typ FIR enthalten ist, durch eine Interpolationsmethode einer Ordnung höher als eins erfolgt, dass die interpolierten Abtastwerte durch ein Berechnen eines gewichteten Mittelwerts (802) von möglichen Interpolationswerten, die ausgehend von Koeffizienten einer Mehrzahl von Interpolationspolynomen einer Ordnung höher als eins (801) berechnet werden, erhalten werden, wobei die Koeffizienten über eine Mehrzahl von Intervallen berechnet werden, die den zeitlichen Ort des zu interpolierenden Abtastwerts abdecken, und dass die interpolierten Abtastwerte ein gemäß einem beschränkten prädiktiven Decodiermodus (1006) decodiertes Signal in einem Übergangsrahmen zwischen einer prädiktiven Decodierung und einer Decodierung durch Transformation vor einem Schritt der Kombination (1008) zwischen gemäß der beschränkten prädiktiven Decodierung decodierten und vervollständigten Abtastwerten und gemäß einer Decodierung durch Transformation (1003) decodierten Abtastwerten in dem Übergangsrahmen vervollständigen.

2. Verfahren nach Anspruch 1, **dadurch gekennzeichnet, dass** die Interpolation vom parabolischen Typ 2. Ordnung ist.

3. Verfahren nach Anspruch 1, **dadurch gekennzeichnet, dass** die Interpolation vom kubischen Typ 3. Ordnung ist und dass die Anzahl der Intervalle, die den zeitlichen Ort des zu interpolierenden Abtastwerts abdecken, 3 beträgt.

4. Verfahren nach einem der Ansprüche 1 bis 3, **dadurch gekennzeichnet, dass** der gewichtete Mittelwert für jeden der möglichen Interpolationswerte mit einem gleichen Gewichtungswert erhalten wird.

5. Verfahren nach Anspruch 3, **dadurch gekennzeichnet, dass** für den für das zentrale Intervall der drei Intervalle berechneten Interpolationswert zur Berechnung des gewichteten Mittelwerts ein unterschiedlicher Gewichtungswert angewendet wird.

6. Verfahren nach einem der Ansprüche 1 bis 3, **dadurch gekennzeichnet, dass** die auf die möglichen Interpolationswerte angewendeten Gewichtungswerte in Abhängigkeit von einem Frequenzkriterium des zu interpolierenden Abtastwerts bestimmt werden.

7. Audiofrequenzsignal-Decodierer, der eine Vorrichtung (800) zur Neuabtastung eines Audiofrequenzsignals umfasst, **dadurch gekennzeichnet, dass** das Neuabtasten durch eine Interpolationsmethode einer Ordnung höher als eins an einem Signal durchgeführt wird, das in einem Speicher eines Neuabtastfilters vom Typ FIR enthalten ist, wobei die Vorrichtung zur Neuabtastung Folgendes umfasst:
- ein Rechenmodul (801), das in der Lage ist, mögliche Interpolationswerte ausgehend von Koeffizienten einer Mehrzahl von Interpolationspolynomen einer Ordnung höher als eins zu berechnen, wobei die Koeffizienten für eine Mehrzahl von Intervallen berechnet werden, die den zeitlichen Ort eines zu interpolierenden Abtastwerts abdecken; und
- ein Modul (802) zum Erhalten des zu interpolierenden Abtastwerts durch Berechnen eines gewichteten Mittelwerts der möglichen Interpolationswerte, die aus dem Rechenmodul hervorgegangen sind; wobei der Decodierer ferner Folgendes umfasst:
- ein Modul (1006) zur beschränkten prädiktiven Decodierung, das in der Lage ist, eine beschränkte Decodierung in einem Übergangsrahmen zwischen einer prädiktiven Decodierung und einer Decodierung durch Transformation durchzuführen, wobei die interpolierten Abtastwerte das beschränkte decodierte Signal in dem Übergangsrahmen vervollständigen; und
- ein Kombinationsmodul (1008), das in der Lage ist, einen Schritt der Kombination zwischen gemäß der beschränkten prädiktiven Decodierung decodierten und vervollständigten Abtastwerten und gemäß einer Decodierung durch Transformation decodierten Abtastwerten in dem Übergangsrahmen durchzuführen.

8. Computerprogramm, das Codeanweisungen umfasst, die bei der Ausführung dieser Anweisungen durch einen Prozessor die Schritte des Verfahrens zum Neuabtasten nach einem der Ansprüche 1 bis 6 ausführen.

9. Speichermedium, das von einem Prozessor gelesen werden kann und auf dem ein Computerprogramm gespeichert ist, das Anweisungen zum Ausführen der Schritte des Verfahrens zum Neuabtasten nach einem der Ansprüche 1 bis 6 umfasst.

## Claims

1. A method for resampling an audio frequency signal in an audio frequency signal decoding, **characterized in that** the resampling is performed on a signal contained in a memory of an FIR type resampling filter using an interpolation method of an order greater than one, **in that** the interpolated samples are obtained by calculating a weighted average (802) of possible interpolation values calculated on the basis of coefficients of a plurality of interpolation polynomials of an order higher than one (801), the coefficients being calculated over a plurality of intervals covering the temporal location of the sample to be interpolated, and **in that** the interpolated samples complement a signal decoded according to a restricted predictive decoding mode (1006) in a transition frame between predictive decoding and transform-based decoding, before a step (1008) of combining samples decoded according to the restricted predictive decoding and complemented and samples decoded according to transform-based decoding (1003) in the transition frame.

2. The method as claimed in claim 1, **characterized in that** the interpolation is of 2nd order parabolic type.

3. The method as claimed in claim 1, **characterized in that** the interpolation is of 3rd order cubic type and **in that** the number of intervals covering the temporal location of the sample to be interpolated is 3.

4. The method as claimed in one of claims 1 to 3, **characterized in that** the weighted average is obtained with the same weighting value for each of the possible interpolation values.

5. The method as claimed in claim 3, **characterized in that** a different weighting value is applied to the interpolation value calculated for the central interval of the three intervals and for the calculation of the weighted average.

6. The method as claimed in one of claims 1 to 3, **characterized in that** the weighting values applied to the possible interpolation values are determined as a function of a frequency criterion of the sample to be interpolated.

7. An audio frequency signal decoder comprising a device (800) for resampling an audio frequency signal, **characterized in that** the resampling is performed by an interpolation method of an order greater than one, on a signal contained in a memory of an FIR type resampling filter, the resampling device comprising:
- a calculation module (801) capable of calculating possible interpolation values on the basis of coefficients of a plurality of interpolation polynomials of an order greater than one, the coefficients being calculated for a plurality of intervals covering the temporal location of a sample to be interpolated; and
- a module (802) for obtaining the sample to be interpolated by calculating a weighted average of the possible interpolation values from the calculating module; the decoder further comprising:
- a restricted predictive decoding module (1006) able to implement restricted decoding in a transition frame between predictive decoding and transform-based decoding, the interpolated samples complementing the restricted decoded signal in the transition frame; and
- a combination module (1008) able to implement a step of combining samples decoded using restricted predictive decoding and complemented with samples decoded using transform-based decoding in the transition frame.

8. A computer program comprising code instructions for implementing the steps of the resampling method as claimed in one of claims 1 to 6 when these instructions are executed by a processor.

9. A computer-readable storage medium, on which a computer program is recorded, comprising code instructions for executing the steps of the resampling method as claimed in one of claims 1 to 6.
